# EUROPEAN PATENT APPLICATION

(11) **EP 1 065 595 A1**
(43) Date of publication of application: **03.01.2001**
(21) Application number: 99305181.2
(22) Date of filing: 30.06.1999
(51) Int. Cl.: G06F 11/10, H03M 13/00

(54) **Statistics signature generation and analysis**

(71) Applicant: Texas Instruments Incorporated, Dallas, Texas 75251 (US); TEXAS INSTRUMENTS LIMITED, Northampton NN4 7ZE (GB)
(72) Inventor: Hall, Christopher, Northampton NN1 5EU (GB); Harrison, Robert, East Hunsbury, Northampton NN4 0FP (GB); Rowell, Anthony, Irchester, Northants. NN29 7ED (GB); Bhandal, Amarjit, Daventry, Northants. NN11 5EY (GB)
(74) Representative: Holt, Michael

(57) **Abstract**

The present invention provides for a statistics Cyclic Redundancy Check (CRC) (108) wherein the statistics CRC (108) is representative of the values contained within a statistics RAM (110). The statistics CRC (108) is then used to reduce test vectors by allowing the validity of the statistics to be determined by reading this signature instead of reading all the individual statistics. The signature is regenerated for each complete pass of the statistics, and the contents of this register are only updated when the pass is complete.

## Description

### TECHNICAL FIELD OF THE INVENTION

This invention relates generally to statistical analysis and more particularly to improved methods of storing and analyzing statistics.

### BACKGROUND OF THE INVENTION

The generation and analysis of statistics is useful to track and test the performance of many processes. In certain systems, however, the amount of statistics needed becomes cumbersome in that the amount of time it takes to manipulate the data and the amount of memory needed to store the data increases. One particular application where this is true is in the generation, storage and manipulation of network statistics.

Thus, there is a need for a method and system of managing large amounts of statistical data.

### SUMMARY OF THE INVENTION

The present invention provides for a statistics Cyclic Redundancy Check (CRC) wherein the statistics CRC is representative of the values contained within the statistics RAM. The statistics CRC is then used to reduce test vectors by allowing the validity of the statistics to be determined by reading this signature instead of reading all the individual statistics. The signature is regenerated for each complete pass of the statistics, and the contents of this register are only updated when the pass is complete.

These and other features of the invention that will be apparent to those skilled in the art from the following detailed description of the invention, taken together with the accompanying drawings.

### DESCRIPTION OF THE DRAWINGS

Fig. 1 is a block diagram of a system for statistics CRC signature generation in accordance with the present invention; and
Fig. 2 is a flow diagram illustrating use of the CRC signature generated in accordance with the present invention.

### DETAILED DESCRIPTION OF THE INVENTION

The present invention provides for a statistics Cyclic Redundancy Check (CRC) wherein the statistics CRC is representative of the values contained within the statistics RAM. The statistics CRC is then used to reduce test vectors by allowing the validity of the statistics to be determined by reading this signature instead of reading all the individual statistics. The signature is regenerated for each complete pass of the statistics, and the contents of this register are only updated when the pass is complete. This statistics CRC is thus a signature which can be used to represent the data from which it was generated.

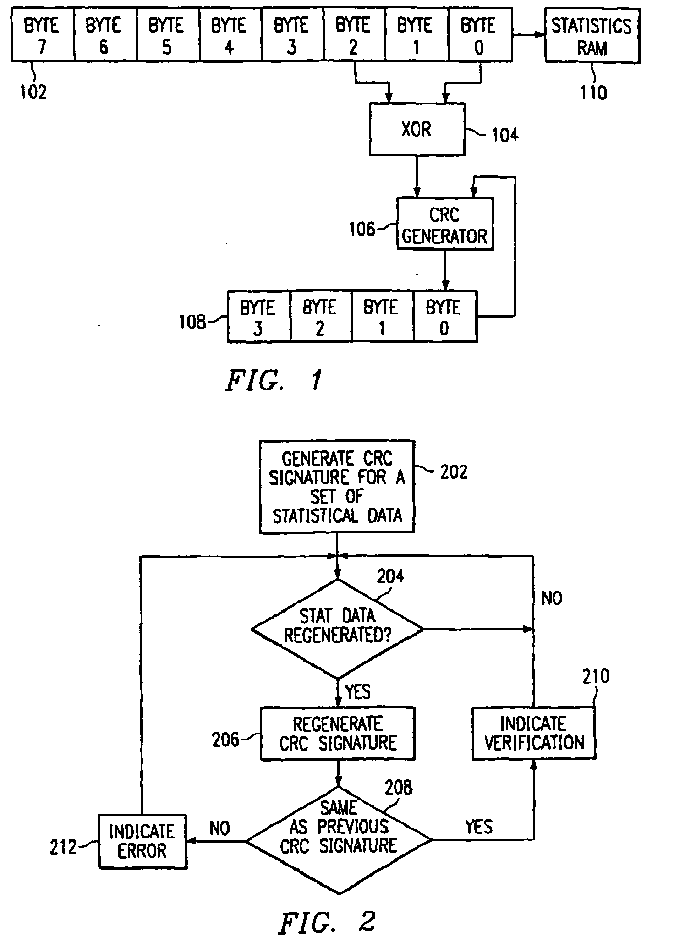

One embodiment of the present invention is shown in Fig. 1. Each time a 64-bit statistic 102 is modified and written back to the Statistics RAM 110 16 bits, i.e., bytes 0 and 2, of the 64-bit statistic 102 are exclusived or'd together in XOR 104. The 8-bit result is fed into one input of the CRC generator 106. While bytes 0 and 2 are exlcusive or'd together in the first clock cycle, bytes 1 and 3, bytes 4 and 6, and bytes 5 and 7 are exclusive or'd together during subsequent clock cycles. The second input of the CRC generator 106 is fed from the CRC signature register 108. CRC signature register 108 is a rolling 32-bit register which holds each resulting CRC signature. The CRC generator 106 uses the two 8-bit inputs to generate a new low order byte in the CRC signature register 108. At predetermined intervals, the resulting CRC signature is stored in the statistics RAM 110 along with the data that the CRC signature represents.

Fig. 2 shows a flow diagram illustrating use of the CRC signature generated in accordance with the present invention. At block 202, a CRC signature is generated for a set of statistical data. At decision block 204, if the statistical data if regenerated, then processing continues at block 206 where the CRC signature is accordingly regenerated. Otherwise, processing continues at decision block 204. After processing at block 206, processing continues at decision block 208 where the regenerated CRC signature is compared with the previous CRC signature generated for the set of statistical data. If, at decision block 208 the CRC signatures are the same, processing continues at block 210 where a signal indicating verification of the statistical data is generated. Otherwise processing continues at block 213 where a signal indication an error in the statistical data is generated instead.

### OTHER EMBODIMENTS

Although the present invention and its advantages have been described in detail, it should be understood that various changes, substitutions and alterations can be made herein without departing from the spirit and scope of the invention as defined by the appended claims.

## Claims

1. A method of verifying statistical data comprising the steps of:
generating a first CRC signature associated with the statistical data;
when the statistical data is regenerated:
regenerating said CRC signature
if said regenerated CRC signature is the same as the first CRC signature then generating a signal to indicate verification of the statistical data; and
if said regenerated CRC signature is not the same as the first CRC signature then generating a signal to indicate an error in the statistical data.
